# EUROPEAN PATENT APPLICATION

(11) **EP 4 629 228 A1**
(43) Date of publication of application: **08.10.2025**
(21) Application number: 25161254.5
(22) Date of filing: 03.03.2025
(51) Int. Cl.: G09G 3/3233

(54) **DISPLAY DEVICE**

(30) Priority: 03.04.2024 US 202418625223
(71) Applicant: InnoLux Corporation, Jhunan Town Miao li 35053 (TW)
(72) Inventor: WATSUDA, Hirofumi, 35053 Jhunan Town, Miaoli County (TW)
(74) Representative: Becker, Eberhard

(57) **Abstract**

The display device (100) includes a circuit substrate (101) and a plurality of pixels (P(1,1)~P(R,S)). The plurality of pixels (P(1,1)~P(R,S)) is electrically connected to the circuit substrate (101). Each of the plurality of pixels (P(1,1)~P(R,S)) includes a first sub-pixel (PR) and a second sub-pixel (PG). The first sub-pixel (PR) includes at least two first light emitting units (RD_1, RD_2) connected in series. The second sub-pixel (PG) includes at least one second light emitting unit (GD). The number of the at least two first light emitting units (RD_1, RD_2) of the first sub-pixel (PR) is greater than the number of the at least one second light emitting unit (GD) of the second sub-pixel (PG). The at least two first light emitting units (RD_1, RD_2) are electrically connected to a first reference voltage (PVSS2). The at least one second light emitting unit (GD) is electrically connected to a second reference voltage (PVSS).

## Description

### BACKGROUND

### Technical Field

The disclosure relates a device; particularly, the disclosure relates to a display device.

### Description of Related Art

In the design stage of LED displays, improving power efficiency is a critical issue if high-brightness display effects are to be pursued.

### SUMMARY

The display device of the disclosure includes a circuit substrate and a plurality of pixels. The plurality of pixels are disposed on the circuit substrate, and electrically connected to the circuit substrate. Each of the plurality of pixels includes a first sub-pixel and a second sub-pixel. The first sub-pixel includes at least two first light emitting units connected in series. The second sub-pixel includes at least one second light emitting unit. The number of the at least two first light emitting units of the first sub-pixel is greater than the number of the at least one second light emitting unit of the second sub-pixel. The at least two first light emitting units are electrically connected to a first reference voltage. The at least one second light emitting unit is electrically connected to a second reference voltage. The first reference voltage is different from the second reference voltage.

The display device of the disclosure includes a circuit substrate and a plurality of pixels. The plurality of pixels are disposed on the circuit substrate, and electrically connected to the circuit substrate. Each of the plurality of pixels includes a first sub-pixel and a second sub-pixel. The first sub-pixel includes at least one first light emitting unit and a first light conversion layer. The second sub-pixel includes at least two second light emitting units connected in series and a second light conversion layer. The number of the at least one first light emitting unit of the first sub-pixel is less than the number of the at least two second light emitting units of the second sub-pixel. The first light conversion layer is configured to convert light with a first wavelength to light with a second wavelength. The second conversion layer is configured to convert the light with the first wavelength to light with a third wavelength. The second wavelength is different from the third wavelength.

Based on the above, according to the display device of the disclosure, the display device may improve power efficiency.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a schematic diagram of a display device according to an embodiment of the disclosure.
FIG. 2 is a schematic diagram of a pixel circuit according to an embodiment of the disclosure.
FIG. 3 is a schematic diagram of a pixel circuit according to an embodiment of the disclosure.
FIG. 4 is a schematic diagram of a pixel circuit according to an embodiment of the disclosure.

### DESCRIPTION OF THE EMBODIMENTS

Reference will now be made in detail to the exemplary embodiments of the disclosure, examples of which are illustrated in the accompanying drawings. Whenever possible, the same reference numbers are used in the drawings and the description to refer to the same or like components.

Certain terms are used throughout the specification and appended claims of the disclosure to refer to specific components. Those skilled in the art should understand that electronic device manufacturers may refer to the same components by different names. This article does not intend to distinguish those components with the same function but different names. In the following description and rights request, the words such as "comprise" and "include" are open-ended terms, and should be explained as "including but not limited to...".

The term "coupling (or connection)" used throughout the whole specification of the present application (including the appended claims) may refer to any direct or indirect connection means. For example, if the text describes that a first device is coupled (or connected) to a second device, it should be interpreted that the first device may be directly connected to the second device, or the first device may be indirectly connected through other devices or certain connection means to be connected to the second device. The terms "first", "second", and similar terms mentioned throughout the whole specification of the present application (including the appended claims) are merely used to name discrete elements or to differentiate among different embodiments or ranges. Therefore, the terms should not be regarded as limiting an upper limit or a lower limit of the quantity of the elements and should not be used to limit the arrangement sequence of elements. In addition, wherever possible, elements/components/steps using the same reference numerals in the drawings and the embodiments represent the same or similar parts. Reference may be mutually made to related descriptions of elements/components/steps using the same reference numerals or using the same terms in different embodiments.

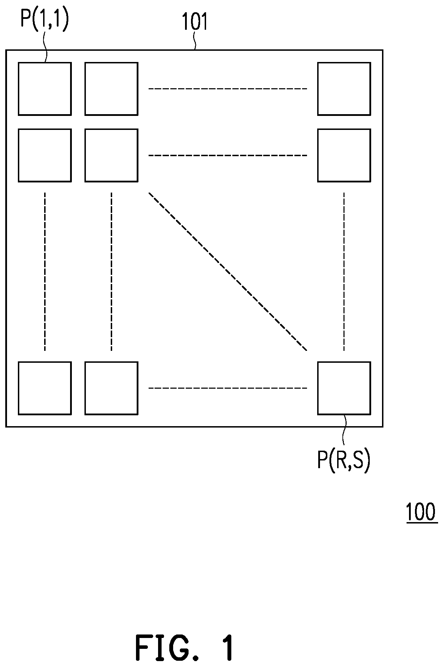

FIG. 1 is a schematic diagram of a display device according to an embodiment of the disclosure. Referring to FIG. 1, a display device 100 includes a circuit substrate 101 and a plurality of pixels P(1,1) to P(R,S), where R and S are positive integers. The plurality of pixels P(1,1) to P(R,S) are electrically connected to the circuit substrate 101. The plurality of pixels P(1,1) to P(R,S) form a pixel array, but the disclosure does not limit the shape of the circuit substrate 101 and the shape of the pixel array. The circuit substrate 101 may be a glass substrate, but the disclosure is also not limited thereto. The circuit substrate 101 may further includes related driving circuits and circuit traces.

In the embodiment of the disclosure, the display device 100 may be an active matrix light emitting diode (AM-LED) display device, but the disclosure is not limited thereto. In some embodiment of the disclosure, the display device 100 may, for example, be adapted to a liquid crystal, a light emitting diode, a quantum dot (QD), a fluorescence, a phosphor, other suitable display medium, or the combination of the aforementioned material, but the disclosure is not limited thereto. The light emitting diode may include, for example, organic light emitting diode (OLED), mini light emitting diode (Mini LED), micro light emitting diode (Micro LED), or quantum dot light emitting diode (QDLED) or other suitable materials. The materials may be arranged and combined arbitrarily, but the disclosure is not limited to thereto. The display device 100 may further include peripheral systems such as driving system, control system, light source system, shelf system, and the like to support the light emitting device.

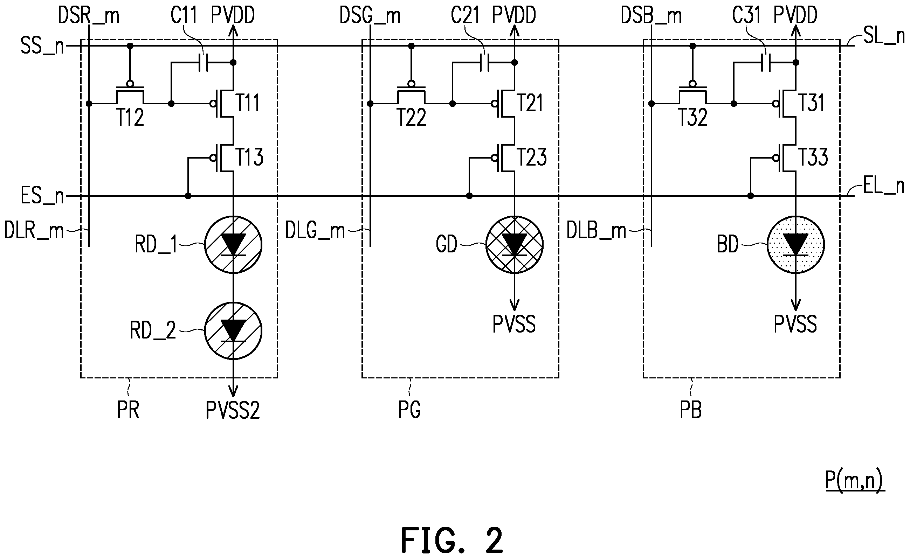

FIG. 2 is a schematic diagram of a pixel circuit according to an embodiment of the disclosure. Referring to FIG. 2, each of the plurality of pixels P(1,1) to P(R,S) may realize as a circuit architecture of a pixel P(m,n) of FIG. 2, where m is between 1 and R, and n is between 1 and S. In the embodiment of the disclosure, the pixel P(m,n) includes a first sub-pixel PR, a second sub-pixel PG, and a third sub-pixel PB. The first sub-pixel PR includes a driving transistor T11, a data scan transistor T12, an emission control transistor T13, a storage capacitor C11, and two light emitting units RD_1 and RD_2. A first terminal of the driving transistor T11 is electrically connected to a reference voltage PVDD and a first terminal of the storage capacitor C11. A control terminal of the driving transistor T11 is electrically connected to a second terminal of the storage capacitor C11 and a second terminal of the data scan transistor T12. A second terminal of the driving transistor T11 is electrically connected to a first terminal of the emission control transistor T13. A first terminal of the data scan transistor T12 is electrically connected to a data signal line DLR_m to receive a data signal DSR_m. A second terminal of the data scan transistor T12 is electrically connected to the control terminal of the driving transistor T11 and the second terminal of the storage capacitor C11. A control terminal of the data scan transistor T12 is electrically connected to a scan signal line SL_n to receive a scan signal SS_n. A first terminal of the emission control transistor T13 is electrically connected to the second terminal of the driving transistor T11. A second terminal of the emission control transistor T13 is electrically connected to the two light emitting units RD_1 and RD_2 connected in series. A control terminal of the emission control transistor T13 is electrically connected to an emission signal line EL_n to receive an emission signal ES_n. The second terminal of the emission control transistor T13 is electrically connected to an anode of the light emitting unit RD_1. A cathode of the light emitting unit RD_1 is electrically connected to an anode of the light emitting unit RD_2. A cathode of the light emitting unit RD_2 is electrically connected to a reference voltage PVSS2.

The second sub-pixel PG includes a driving transistor T21, a data scan transistor T22, an emission control transistor T23, a storage capacitor C21, and a light emitting unit GD. A first terminal of the driving transistor T21 is electrically connected to the reference voltage PVDD and a first terminal of the storage capacitor C21. A control terminal of the driving transistor T21 is electrically connected to a second terminal of the storage capacitor C21 and a second terminal of the data scan transistor T22. A second terminal of the driving transistor T21 is electrically connected to a first terminal of the emission control transistor T23. A first terminal of the data scan transistor T22 is electrically connected to a data signal line DLG_m to receive a data signal DSG_m. A second terminal of the data scan transistor T22 is electrically connected to the control terminal of the driving transistor T21 and the second terminal of the storage capacitor C21. A control terminal of the data scan transistor T22 is electrically connected to the scan signal line SL_n to receive the scan signal SS_n. A first terminal of the emission control transistor T23 is electrically connected to the second terminal of the driving transistor T21. A second terminal of the emission control transistor T23 is electrically connected to an anode the light emitting unit GD. A control terminal of the emission control transistor T23 is electrically connected to the emission signal line EL_n to receive the emission signal ES_n. A cathode of the light emitting unit GD is further electrically connected to a reference voltage PVSS. The reference voltage PVSS may be different from the reference voltage PVSS2.

The third sub-pixel PB includes a driving transistor T31, a data scan transistor T32, an emission control transistor T33, a storage capacitor C31, and a light emitting unit BD. A first terminal of the driving transistor T31 is electrically connected to the reference voltage PVDD and a first terminal of the storage capacitor C31. A control terminal of the driving transistor T31 is electrically connected to a second terminal of the storage capacitor C31 and a second terminal of the data scan transistor T32. A second terminal of the driving transistor T31 is electrically connected to a first terminal of the emission control transistor T33. A first terminal of the data scan transistor T32 is electrically connected to a data signal line DLB_m to receive a data signal DSB_m. A second terminal of the data scan transistor T32 is electrically connected to the control terminal of the driving transistor T31 and the second terminal of the storage capacitor C31. A control terminal of the data scan transistor T32 is electrically connected to the scan signal line SL_n to receive the scan signal SS_n. A first terminal of the emission control transistor T33 is electrically connected to the second terminal of the driving transistor T31. A second terminal of the emission control transistor T33 is electrically connected to an anode of the light emitting unit BD. A control terminal of the emission control transistor T33 is electrically connected to the emission signal line EL_n to receive the emission signal ES_n. A cathode of the light emitting unit BD is further electrically connected to the reference voltage PVSS.

In the embodiment of the disclosure, the driving transistors T11, T21, T31, the data scan transistors T12, T22, T32, and the emission control transistors T13, T23, T33 may be p-type transistors, but the disclosure is not limited thereto. The driving transistors T11, T21, T31, the data scan transistors T12, T22, T32, and the emission control transistors T13, T23, T33 may also be thin-film transistors.

In the embodiment of the disclosure, the first sub-pixel PR may be a red sub-pixel, the second sub-pixel PG may be a green sub-pixel, and the third sub-pixel PB may be a blue sub-pixel. Each of the light emitting units RD_1 and RD_2 may be a red light emitting unit. The light emitting unit GD may be a green light emitting unit. The light emitting unit BD may be a blue light emitting unit. In the embodiment of the disclosure, the light emitting units RD_1 and RD_2 may have the lowest efficiency compared to the light emitting unit GD and the light emitting unit BD, therefore the first sub-pixel PR may utilize the two light emitting units RD_1 and RD_2 to emit red light. In another embodiment of the disclosure, the light emitting units RD_1 and RD_2 may have the lowest forward voltage compared to the light emitting unit GD and the light emitting unit BD.

However, the number of light emitting units in each of the first sub-pixel PR, the second sub-pixel PG, and the third sub-pixel PB of the disclosure is not limited to FIG. 2. In one embodiment of the disclosure, the first sub-pixel PR may include at least two red light emitting units connected in series, the second sub-pixel PG may include at least one green light emitting unit, and the third sub-pixel PB may include at least one blue light emitting unit. The number of the at least two red light emitting units connected in series of the first sub-pixel PR is greater than the number of the at least one green light emitting unit of the second sub-pixel PG. The number of the at least two red light emitting units connected in series of the first sub-pixel PR is greater than the number of the at least one blue light emitting unit of the third sub-pixel PB.

In addition, in the embodiment of the disclosure, the reference voltage PVDD is higher than the reference voltage PVSS and the reference voltage PVSS2. The reference voltage PVSS2 may be lower than the reference voltage PVSS. That is, the sub-pixels PG and PB may be operated at the lower power supply voltage (PVDD-PVSS) compared to the power supply voltage of the sub-pixel PR (PVDD-PVSS2), thereby reducing the power consumption of the sub-pixels PG and PB, and improving the driving efficiency.

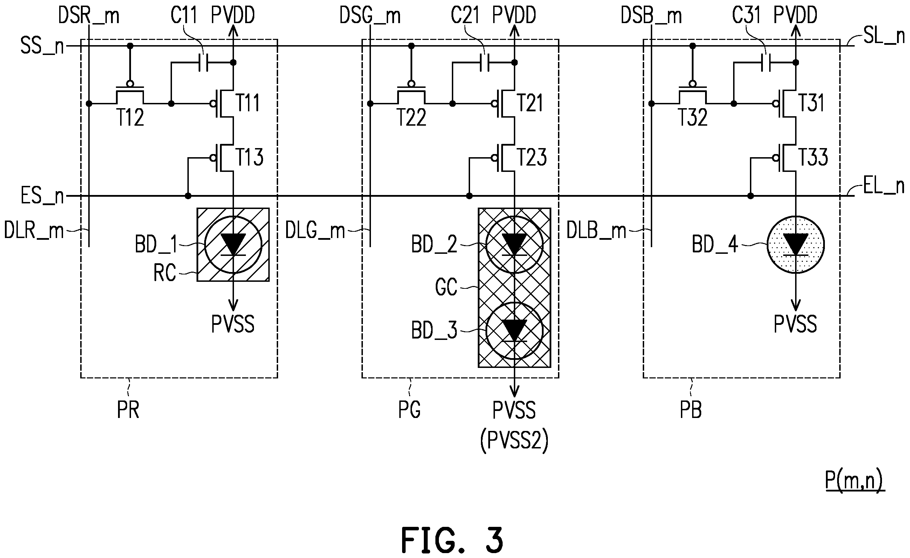

FIG. 3 is a schematic diagram of a pixel circuit according to an embodiment of the disclosure. Referring to FIG. 3, each of the plurality of pixels P(1,1) to P(R, S) may realize as a circuit architecture of a pixel P(m,n) of FIG. 3. In the embodiment of the disclosure, the pixel P(m,n) includes a first sub-pixel PR, a second sub-pixel PG, and a third sub-pixel PB. The first sub-pixel PR includes a driving transistor T11, a data scan transistor T12, an emission control transistor T13, a storage capacitor C11, a light emitting unit BD_1, and a light conversion layer RC. A first terminal of the driving transistor T11 is electrically connected to a reference voltage PVDD and a first terminal of the storage capacitor C11. A control terminal of the driving transistor T11 is electrically connected to a second terminal of the storage capacitor C11 and a second terminal of the data scan transistor T12. A second terminal of the driving transistor T11 is electrically connected to a first terminal of the emission control transistor T13. A first terminal of the data scan transistor T12 is electrically connected to a data signal line DLR_m to receive a data signal DSR_m. A second terminal of the data scan transistor T12 is electrically connected to the control terminal of the driving transistor T11 and the second terminal of the storage capacitor C11. A control terminal of the data scan transistor T12 is electrically connected to a scan signal line SL_n to receive a scan signal SS_n. A first terminal of the emission control transistor T13 is electrically connected to the second terminal of the driving transistor T11. A second terminal of the emission control transistor T13 is electrically connected to an anode of the light emitting unit BD_1. A control terminal of the emission control transistor T13 is electrically connected to an emission signal line EL_n to receive an emission signal ES_n. A cathode of the light emitting unit BD_1 is further electrically connected to a reference voltage PVSS. The light conversion layer RC covers a light emitting surface of the light emitting unit BD_1. The light conversion layer RC is configured to convert light with a first wavelength provided by the light emitting unit BD_1 to light with a second wavelength. In the embodiment of the disclosure, the second wavelength may be longer than the first wavelength.

The second sub-pixel PG includes a driving transistor T21, a data scan transistor T22, an emission control transistor T23, a storage capacitor C21, two light emitting units BD_2 and BD_3, and a light conversion layer GC. A first terminal of the driving transistor T21 is electrically connected to the reference voltage PVDD and a first terminal of the storage capacitor C21. A control terminal of the driving transistor T21 is electrically connected to a second terminal of the storage capacitor C21 and a second terminal of the data scan transistor T22. A second terminal of the driving transistor T21 is electrically connected to a first terminal of the emission control transistor T23. A first terminal of the data scan transistor T22 is electrically connected to a data signal line DLG_m to receive a data signal DSG_m. A second terminal of the data scan transistor T22 is electrically connected to the control terminal of the driving transistor T21 and the second terminal of the storage capacitor C21. A control terminal of the data scan transistor T22 is electrically connected to the scan signal line SL_n to receive the scan signal SS_n. A first terminal of the emission control transistor T23 is electrically connected to the second terminal of the driving transistor T21. A second terminal of the emission control transistor T23 is electrically connected to the two light emitting units BD_2 and BD_3 connected in series. A control terminal of the emission control transistor T23 is electrically connected to the emission signal line EL_n to receive the emission signal ES_n. The second terminal of the emission control transistor T23 is electrically connected to an anode of the light emitting unit BD_2. A cathode of the light emitting unit BD_2 is electrically connected to an anode of the light emitting unit BD_3. A cathode of the light emitting unit BD_3 is electrically connected to the reference voltage PVSS. The light conversion layer GC covers light emitting surfaces of the two light emitting units BD_2 and BD_3. The light conversion layer GC is configured to convert light with the first wavelength provided by the two light emitting units BD_2 and BD_3 to light with a third wavelength. The second wavelength is different from the third wavelength. In the embodiment of the disclosure, the second wavelength may be longer than the third wavelength.

The third sub-pixel PB includes a driving transistor T31, a data scan transistor T32, an emission control transistor T33, a storage capacitor C31, and a light emitting unit BD_4. A first terminal of the driving transistor T31 is electrically connected to the reference voltage PVDD and a first terminal of the storage capacitor C31. A control terminal of the driving transistor T31 is electrically connected to a second terminal of the storage capacitor C31 and a second terminal of the data scan transistor T32. A second terminal of the driving transistor T31 is electrically connected to a first terminal of the emission control transistor T33. A first terminal of the data scan transistor T32 is electrically connected to a data signal line DLB_m to receive a data signal DSB_m. A second terminal of the data scan transistor T32 is electrically connected to the control terminal of the driving transistor T31 and the second terminal of the storage capacitor C31. A control terminal of the data scan transistor T32 is electrically connected to the scan signal line SL_n to receive the scan signal SS_n. A first terminal of the emission control transistor T33 is electrically connected to the second terminal of the driving transistor T31. A second terminal of the emission control transistor T33 is electrically connected to an anode of the light emitting unit BD_4. A control terminal of the emission control transistor T33 is electrically connected to the emission signal line EL_n to receive the emission signal ES_n. A cathode of the light emitting unit BD_4 is further electrically connected to the reference voltage PVSS. The light emitting unit BD_4 is configured to provide the light with the first wavelength.

In the embodiment of the disclosure, the first sub-pixel PR may be a red sub-pixel, the second sub-pixel PG may be a green sub-pixel, and the third sub-pixel PB may be a blue sub-pixel. Each of the light emitting units BD_1 to BD_4 may be a blue light emitting unit. Thus, the light with the first wavelength may be blue light. The light with the second wavelength may be red light. The light with the third wavelength may be green light.

In the embodiment of the disclosure, the light conversion efficiency of the light conversion layer GC may be lower than the light conversion efficiency of the light conversion layer RC, therefore the second sub-pixel PG may utilize the two light emitting units BD_2 and BD_3 to provide a light source. In the embodiment of the disclosure, the light conversion layer RC and the light conversion layer GC may be quantum dot color conversion (QDCC) layers, but the disclosure is not limited thereto.

However, the number of light emitting units in each of the first sub-pixel PR, the second sub-pixel PG, and the third sub-pixel PB of the disclosure is not limited to FIG. 3. In one embodiment of the disclosure, the first sub-pixel PR may include at least one light emitting unit, the second sub-pixel PG may include at least two light emitting units connected in series, and the third sub-pixel PB may include at least one light emitting unit. The number of the at least one light emitting unit of the first sub-pixel PR is less than the number of the at least two light emitting units connected in series of the second sub-pixel PG. The number of the at least one light emitting unit of the third sub-pixel PB is less than the number of the at least two light emitting units connected in series of the second sub-pixel PG. Moreover, the at least one light emitting unit of the first sub-pixel PR and the at least two light emitting units of the second sub-pixel PG are the same color light emitting unit, but the disclosure is not limited thereto.

In addition, in the embodiment of the disclosure, the reference voltage PVDD is higher than the reference voltage PVSS. In one embodiment of the disclosure, the cathode of the light emitting unit BD_3 may also be electrically connected to the reference voltage PVSS2. The reference voltage PVSS is different from the reference voltage PVSS2. The reference voltage PVDD is higher than the reference voltage PVSS and the reference voltage PVSS2. The reference voltage PVSS may be higher than the reference voltage PVSS2. That is, the sub-pixels PR and PB may be operated at the lower power supply voltage (PVDD-PVSS) compared to the power supply voltage of the sub-pixel PG (PVDD-PVSS2), thereby reducing the power consumption of the sub-pixels PR and PB, and improving the driving efficiency.

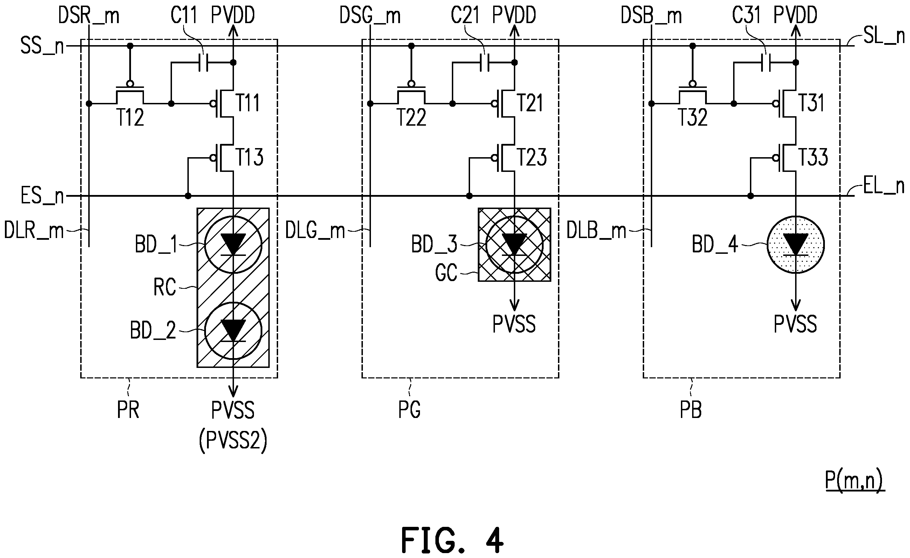

FIG. 4 is a schematic diagram of a pixel circuit according to an embodiment of the disclosure. Referring to FIG. 4, each of the plurality of pixels P(1,1) to P(R,S) may realize as a circuit architecture of a pixel P(m,n) of FIG. 4. In the embodiment of the disclosure, the pixel P(m,n) includes a first sub-pixel PR, a second sub-pixel PG, and a third sub-pixel PB. The first sub-pixel PR includes a driving transistor T11, a data scan transistor T12, an emission control transistor T13, a storage capacitor C11, two light emitting units BD_1 and BD_2, and a light conversion layer RC. A first terminal of the driving transistor T11 is electrically connected to a reference voltage PVDD and a first terminal of the storage capacitor C11. A control terminal of the driving transistor T11 is electrically connected to a second terminal of the storage capacitor C11 and a second terminal of the data scan transistor T12. A second terminal of the driving transistor T11 is electrically connected to a first terminal of the emission control transistor T13. A first terminal of the data scan transistor T12 is electrically connected to a data signal line DLR_m to receive a data signal DSR_m. A second terminal of the data scan transistor T12 is electrically connected to the control terminal of the driving transistor T11 and the second terminal of the storage capacitor C11. A control terminal of the data scan transistor T12 is electrically connected to a scan signal line SL_n to receive a scan signal SS_n. A first terminal of the emission control transistor T13 is electrically connected to the second terminal of the driving transistor T11. A second terminal of the emission control transistor T13 is electrically connected to the two light emitting units BD_1 and BD_2 connected in series. A control terminal of the emission control transistor T13 is electrically connected to an emission signal line EL_n to receive an emission signal ES_n. The second terminal of the emission control transistor T13 is electrically connected to an anode of the light emitting unit BD_1. A cathode of the light emitting unit BD_1 is electrically connected to an anode of the light emitting unit BD_2. A cathode of the light emitting unit BD_2 is electrically connected to a reference voltage PVSS. The light conversion layer RC covers the two light emitting units BD_1 and BD_2. The light conversion layer RC is configured to convert light with a first wavelength provided by the two light emitting units BD_1 and BD_2 to light with a second wavelength.

The second sub-pixel PG includes a driving transistor T21, a data scan transistor T22, an emission control transistor T23, a storage capacitor C21, a light emitting unit BD_3, and a light conversion layer GC. A first terminal of the driving transistor T21 is electrically connected to the reference voltage PVDD and a first terminal of the storage capacitor C21. A control terminal of the driving transistor T21 is electrically connected to a second terminal of the storage capacitor C21 and a second terminal of the data scan transistor T22. A second terminal of the driving transistor T21 is electrically connected to a first terminal of the emission control transistor T23. A first terminal of the data scan transistor T22 is electrically connected to a data signal line DLG_m to receive a data signal DSG_m. A second terminal of the data scan transistor T22 is electrically connected to the control terminal of the driving transistor T21 and the second terminal of the storage capacitor C21. A control terminal of the data scan transistor T22 is electrically connected to the scan signal line SL_n to receive the scan signal SS_n. A first terminal of the emission control transistor T23 is electrically connected to the second terminal of the driving transistor T21. A second terminal of the emission control transistor T23 is electrically connected to an anode of the light emitting unit BD_3. A control terminal of the emission control transistor T23 is electrically connected to an emission signal line EL_n to receive an emission signal ES_n. A cathode of the light emitting unit BD_3 is further electrically connected to the reference voltage PVSS. The light conversion layer GC covers the light emitting unit BD_3. The light conversion layer GC is configured to convert light with the first wavelength provided by the light emitting unit BD_3 to light with a third wavelength. The second wavelength is different from the third wavelength. In the embodiment of the disclosure, the third wavelength may be shorter than the second wavelength.

The third sub-pixel PB includes a driving transistor T31, a data scan transistor T32, an emission control transistor T33, a storage capacitor C31, and a light emitting unit BD_4. A first terminal of the driving transistor T31 is electrically connected to the reference voltage PVDD and a first terminal of the storage capacitor C31. A control terminal of the driving transistor T31 is electrically connected to a second terminal of the storage capacitor C31 and a second terminal of the data scan transistor T32. A second terminal of the driving transistor T31 is electrically connected to a first terminal of the emission control transistor T33. A first terminal of the data scan transistor T32 is electrically connected to a data signal line DLB_m to receive a data signal DSB_m. A second terminal of the data scan transistor T32 is electrically connected to the control terminal of the driving transistor T31 and the second terminal of the storage capacitor C31. A control terminal of the data scan transistor T32 is electrically connected to the scan signal line SL_n to receive the scan signal SS_n. A first terminal of the emission control transistor T33 is electrically connected to the second terminal of the driving transistor T31. A second terminal of the emission control transistor T33 is electrically connected to an anode of the light emitting unit BD_4. A control terminal of the emission control transistor T33 is electrically connected to the emission signal line EL_n to receive the emission signal ES_n. A cathode of the light emitting unit BD_4 is further electrically connected to the reference voltage PVSS. The light emitting unit BD_4 is configured to provide the light with the first wavelength.

In the embodiment of the disclosure, the first sub-pixel PR may be a red sub-pixel, the second sub-pixel PG may be a green sub-pixel, and the third sub-pixel PB may be a blue sub-pixel. Each of the light emitting units BD_1 to BD_4 may be a blue light emitting unit. The light with the first wavelength may be blue light. The light with the second wavelength may be red light. The light with the third wavelength may be green light.

In the embodiment of the disclosure, the light conversion efficiency of the light conversion layer RC may be lower than the light conversion efficiency of the light conversion layer GC, therefore the second sub-pixel PR may utilize the two light emitting units BD_1 and BD_2 to provide a light source.

However, the number of light emitting units in each of the first sub-pixel PR, the second sub-pixel PG, and the third sub-pixel PB of the disclosure is not limited to FIG. 4. In one embodiment of the disclosure, the first sub-pixel PR may include at least two light emitting units connected in series, the second sub-pixel PG may include at least one light emitting unit, and the third sub-pixel PB may include at least one light emitting unit. The number of the at least two light emitting units connected in series of the first sub-pixel PR is greater than the number of the at least one light emitting unit of the second sub-pixel PG. The number of the at least two light emitting units connected in series of the first sub-pixel PR is greater than the number of the at least one light emitting unit of the third sub-pixel PB. Moreover, the at least two light emitting units of the first sub-pixel PR and the at least one second light emitting unit are the same color light emitting unit, but the disclosure is not limited thereto.

In addition, in the embodiment of the disclosure, the reference voltage PVDD is higher than the reference voltage PVSS. In one embodiment of the disclosure, the cathode of the light emitting unit BD_2 may also be electrically connected to the reference voltage PVSS2. The reference voltage PVSS is different from the reference voltage PVSS2. The reference voltage PVDD is higher than the reference voltage PVSS and the reference voltage PVSS2. The reference voltage PVSS may be higher than the reference voltage PVSS2. That is, the light emitting units BD_1 and BD_2 may be operated at lower power supply voltage, thereby reducing the power consumption of the light emitting units BD_1 and BD_2, and improving the driving efficiency. That is, the sub-pixels PG and PB may be operated at the lower power supply voltage (PVDD-PVSS) compared to the power supply voltage of the sub-pixel PR (PVDD-PVSS2), thereby reducing the power consumption of the sub-pixels PG and PB, and improving the driving efficiency.

In summary, the display device of the disclosure can achieve good luminous efficiency and driving efficiency through series connection of the light emitting units on the specific color sub-pixels.

## Claims

1. A display device (100), comprising:
a circuit substrate (101); and
a plurality of pixels (P(1,1)~P(R,S)), disposed on the circuit substrate (101), and electrically connected to the circuit substrate (101),
wherein each of the plurality of pixels (P(1,1)~P(R,S)) comprises a first sub-pixel (PR) and a second sub-pixel (PG), the first sub-pixel (PR) comprises at least two first light emitting units (RD_1, RD_2) connected in series, the second sub-pixel (PG) comprises at least one second light emitting unit (GD),
wherein the number of the at least two first light emitting units (RD_1, RD_2) of the first sub-pixel (PR) is greater than the number of the at least one second light emitting unit (GD) of the second sub-pixel (PG),
wherein the at least two first light emitting units (RD_1, RD_2) are electrically connected to a first reference voltage (PVSS2), the at least one second light emitting unit (GD) is electrically connected to a second reference voltage (PVSS), the first reference voltage (PVSS2) is different from the second reference voltage (PVSS).

2. The display device (100) according to claim 1, wherein the first reference voltage (PVSS2) is lower than the second reference voltage (PVSS).

3. The display device (100) according to claim 1, wherein each of the at least two first light emitting units (RD_1, RD_2) is a red light emitting unit,
wherein each of the at least one second light emitting unit (GD) is a green light emitting unit.

4. The display device (100) according to claim 1, wherein the first sub-pixel (PR) and the second sub-pixel (PG) are further electrically connected to a third reference voltage (PVDD), and the third reference voltage (PVDD) is higher than the first reference voltage (PVSS2) and the second reference voltage (PVSS).

5. The display device (100) according to claim 1, wherein each of the plurality of pixels (P(1,1)~P(R,S)) further comprises a third sub-pixel (PB), the third sub-pixel (PB) comprises at least one third light emitting unit (BD),
wherein the number of the at least two first light emitting units (RD_1, RD_2) of the first sub-pixel (PR) is greater than the number of the at least one third light emitting unit (BD) of the third sub-pixel (PB),
wherein the at least one third light emitting unit (BD) is electrically connected to the second reference voltage (PVSS),
wherein each of the at least one third light emitting unit (BD) is a blue light emitting unit.

6. A display device (100), comprising:
a circuit substrate (101); and
a plurality of pixels (P(1,1)~P(R,S)), disposed on the circuit substrate (101), and electrically connected to the circuit substrate (101),
wherein each of the plurality of pixels (P(1,1)~P(R,S)) comprises a first sub-pixel (PR) and a second sub-pixel (PG), the first sub-pixel (PR) comprises at least one first light emitting unit (BD_1, BD_2) and a first light conversion layer (RC), the second sub-pixel (PG) comprises at least two second light emitting units (BD_2, BD_3) connected in series and a second light conversion layer (GC),
wherein the number of the at least one first light emitting unit (BD_1, BD_2) of the first sub-pixel (PR) is less than the number of the at least two second light emitting units (BD_2, BD_3) of the second sub-pixel (PG),
wherein the first light conversion layer (RC) is configured to convert light with a first wavelength to light with a second wavelength, the second conversion layer (GC) is configured to convert the light with the first wavelength to light with a third wavelength, and the second wavelength is different from the third wavelength.

7. The display device (100) according to claim 6, wherein the second wavelength is longer than the third wavelength.

8. The display device (100) according to claim 6, wherein the light with the first wavelength is blue light, red light, or green light.

9. The display device (100) according to claim 6, wherein the second wavelength is shorter than the third wavelength.

10. The display device (100) according to claim 6, wherein the at least one first light emitting unit (BD_1, BD_2) is electrically connected to a first reference voltage (PVSS, PVSS2), the at least two second light emitting unit (BD_2, BD_3) are electrically connected to a second reference voltage (PVSS, PVSS2), the first reference voltage (PVSS, PVSS2) is different from the second reference voltage (PVSS, PVSS2).

11. The display device (100) according to claim 10, wherein the second reference voltage (PVSS2). is lower than the first reference voltage (PVSS).

12. The display device (100) according to claim 10, wherein the first sub-pixel (PR) and the second sub-pixel (PG) are further electrically connected to a third reference voltage (PVDD), and the third reference voltage (PVDD) is higher than the first reference voltage (PVSS, PVSS2) and the second reference voltage (PVSS, PVSS2).

13. The display device (100) according to claim 6, wherein each of the plurality of pixels (P(1,1)~P(R,S)) further comprises a third sub-pixel (PB), the third sub-pixel (PB) comprises at least one third light emitting unit (BD_4), wherein each of the at least one third light emitting unit (BD_4) is a blue light emitting unit.

14. The display device (100) according to claim 6, wherein the at least one first light emitting unit (BD_1, BD_2) and the at least two second lights emitting unit (BD_2, BD_3) are the same color light emitting unit.

15. The display device (100) according to claim 6, wherein each of the at least one first light emitting unit (BD_1, BD_2) and the at least two second light emitting unit (BD_2, BD_3) is a blue light emitting unit.
